(19) **Europäisches Patentamt**
**European Patent Office**
**Office européen des brevets**

(11) **EP 4 727 013 A1**

(12) **EUROPEAN PATENT APPLICATION**

(43) Date of publication:
**15.04.2026 Bulletin 2026/16**

(51) International Patent Classification (IPC):
**H03K 3/356** (2006.01)

(21) Application number: **25202098.7**

(22) Date of filing: **15.09.2025**

(52) Cooperative Patent Classification (CPC):
**H03K 3/356182**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **10.10.2024 US 202418911650**

(71) Applicant: **STMicroelectronics International N.V.**
**1228 Plan-les-Ouates, Geneva (CH)**

(72) Inventor: **SAINI, Pravesh Kumar**
**201310 Greater Noida, Uttar Pradesh (IN)**

(74) Representative: **Buzzi, Notaro & Antonielli d'Oulx S.p.A.**
**Corso Vittorio Emanuele II, 6**
**10123 Torino (IT)**

(54) **HIGH-VOLTAGE TOLERANT LEVEL SHIFTER CIRCUIT**

(57)     According to an embodiment, a high-voltage tolerant level shifter circuit (400, 500) includes input terminals for receiving complementary PWM input signals (CMDP, CMDN), output terminals for providing complementary output signals (OUTP, OUTN), and a latch circuit for translating the input signals to the output signals. The circuit has terminals for receiving floating ground (VFG) and supply (VFS) voltages, and a control circuit (802) to ensure operation within a known state. The latch circuit includes cross-coupled PMOS and NMOS transistors. NMOS input transistors are coupled to the latch circuit through cascode NMOS transistors. The floating voltages are generated based on a pre-regulated supply voltage (103), tracking ground (GND) over a first voltage range and controlled by ratio relationships over a second range. A monitoring circuit (600) generates control signals based on the pre-regulated supply voltage. The level shifter enables efficient voltage domain transfers at higher operating supplies using low-voltage devices, avoiding additional mask layers and reducing manufacturing costs and complexity.

FIG. 4

EP 4 727 013 A1

## Description

## TECHNICAL FIELD

The present disclosure generally relates to electronic devices and, in particular embodiments, to a high-voltage tolerant level shifter circuit.

## BACKGROUND

In modern electronics, efficient power management is employed to optimize performance, extend battery life, and reduce heat generation. Switched-Mode Power Supplies (SMPS) have become a cornerstone of power management solutions due to their high efficiency and versatility. These systems convert input voltages to different levels required by various components within electronic devices, from smartphones to industrial equipment.

As integrated circuits evolve, they often incorporate multiple voltage domains to balance performance and power consumption. This trend has increased complexity in power management systems, particularly in System-on-Chip (SoC) designs. SoCs typically include various functional blocks such as processors, memory, analog interfaces, and power management units, all integrated onto a single chip. The power management unit, often implementing SMPS technology, efficiently provides appropriate voltage levels to different parts of the chip while adapting to changing load conditions and maintaining high efficiency across various operating scenarios. The challenge is compounded by the continuous drive towards miniaturization and cost reduction in semiconductor manufacturing, pushing designers to innovate in circuit design and layout techniques.

## SUMMARY

Technical advantages are generally achieved by embodiments of this disclosure, which describe a high-voltage tolerant level shifter circuit.

A first aspect relates to a high-voltage tolerant level shifter circuit. The high-voltage tolerant level shifter circuit comprises a first input terminal configured to receive a first pulse-width modulation (PWM) input signal; a second input terminal configured to receive a second PWM input signal complementary to the first PWM input signal; a first output terminal configured to provide a first output signal; a second output terminal configured to provide a second output signal complementary to the first output signal; a latch circuit coupled between the first input terminal and the first output terminal and between the second input terminal and the second output terminal, the latch circuit configured to translate the first PWM input signal and the second PWM input signal to the first output signal and the second output signal; a floating ground voltage input terminal configured to receive a floating ground voltage; a floating supply voltage input terminal configured to receive a floating supply voltage; and a control circuit coupled to the latch circuit and configured to receive control signals to ensure the high-voltage tolerant level shifter circuit operates within a known state.

A second aspect relates to a level shifter system comprising a high-voltage tolerant level shifter circuit including a first input terminal configured to receive a first pulse-width modulation (PWM) input signal, a second input terminal configured to receive a second PWM input signal complementary to the first PWM input signal, a first output terminal configured to provide a first output signal, a second output terminal configured to provide a second output signal complementary to the first output signal, a latch circuit coupled between the first input terminal and the first output terminal and between the second input terminal and the second output terminal, the latch circuit configured to translate the first PWM input signal to the first output signal, a floating ground voltage input terminal, a floating supply voltage input terminal, and a control circuit coupled to the latch circuit and configured to receive control signals to ensure the high-voltage tolerant level shifter circuit operates within a known state. The level shifter system further comprises a floating ground voltage generator circuit coupled to the floating ground voltage input terminal and configured to generate a floating ground voltage; and a floating supply voltage generator circuit coupled to the floating supply voltage input terminal and configured to generate a floating supply voltage. A third aspect relates to a level shifter circuit comprising a first input stage configured to receive a first input signal; a second input stage configured to receive a second input signal complementary to the first input signal; a latch stage coupled to the first input stage and the second input stage, the latch stage including cross-coupled transistors configured to translate the first input signal and the second input signal to a first output signal and a second output signal; a first output stage coupled to the latch stage and configured to provide the first output signal; a second output stage coupled to the latch stage and configured to provide the second output signal; a floating voltage input stage configured to receive a floating ground voltage and a floating supply voltage; and a control stage configured to receive control signals and ensure the level shifter circuit operates within a predetermined voltage range.

Embodiments can be implemented in hardware, software, or any combination thereof.

## BRIEF DESCRIPTION OF THE DRAWINGS

For a more complete understanding of the present disclosure and the advantages thereof, reference is now made to the following descriptions taken in conjunction with the accompanying drawings, in which:

Figure 1 is a simplified block diagram of an embodiment SMPS system within a System on Chip (SoC);
Figure 2 is a schematic of an embodiment ballast circuit, which may be implemented as the ballast circuit in Figure 1;

Figure 3 is a schematic of an embodiment ballast circuit, which may be implemented as the ballast circuit in Figure 1;

Figure 4 is a schematic of an embodiment level shifter circuit, which may be implemented in a high-side driver circuit;

Figure 5 is a schematic of an embodiment of a level shifter circuit, which can be implemented in a high-side driver circuit;

Figure 6 is a block diagram of an embodiment monitoring circuit;

Figure 7 is a block diagram of an embodiment SMPS control logic, which may be implemented as the SMPS control logic in Figure 1; and

Figure 8 is a block diagram of an embodiment system.

## DETAILED DESCRIPTION OF ILLUSTRATIVE EMBODIMENTS

This disclosure provides many applicable inventive concepts that can be embodied in a wide variety of specific contexts. The particular embodiments are merely illustrative of specific configurations and do not limit the scope of the claimed embodiments. Features from different embodiments may be combined to form further embodiments unless noted otherwise. Various embodiments are illustrated in the accompanying drawing figures, where identical components and elements are identified by the same reference number, and repetitive descriptions are omitted for brevity.

Variations or modifications described in one of the embodiments may also apply to others. Further, various changes, substitutions, and alterations can be made herein without departing from the spirit and scope of this disclosure as defined by the appended claims.

While the inventive aspects are described primarily in the context of Switched-Mode Power Supplies (SMPS) in System-on-Chip (SoC) designs, it should also be appreciated that these inventive aspects may also apply to other power management systems. In particular, aspects of this disclosure may similarly apply to voltage regulators in discrete circuit designs, DC-DC converters in portable electronics, and power management integrated circuits (PMICs) used in various applications such as automotive electronics, telecommunications equipment, and industrial control systems.

Embodiments of this disclosure propose a high-voltage tolerant level shifter circuit for use in, for example, SMPS systems and within System-on-Chip (SoC) architectures. The proposed level shifter addresses the challenge of efficiently driving high-side switches in SMPS systems where the control circuitry operates at a lower voltage than the power stage. The proposed circuit enables the translation of low-voltage pulse-width modulation (PWM) signals generated by the SMPS control logic to higher voltage levels suitable for controlling power transistors in the SMPS ballast circuit.

Advantageously, the level shifter circuit can employ low-voltage transistors to operate effectively at higher supply voltages, shifting input signals from, for example, 5V to 8.2V or from 1.8V to 3.3V, depending on the pre-regulated supply voltage. In embodiments, the proposed architecture incorporates an arrangement of n-type metal-oxide-semiconductor (MOSFETs) and p-type MOSFETs, including a latch structure, to ensure reliable signal translation while maintaining signal integrity and timing characteristics. Floating ground ($V_{FG}$) and floating supply ($V_{FS}$) voltages act as cascode voltages to protect the transistors from exceeding their safe operating areas.

In embodiments, the level shifter can maintain safe operation across different voltage domains. By including control signals through a separate monitoring circuit, the level shifter is ensured to transition to a known, safe state when the input supply is outside the proper range. This prevents stress on the transistors and maintains overall system reliability.

The proposed level shifter offers several advantages over conventional designs. Firstly, it allows for standard low-voltage devices in higher-voltage applications, eliminating the need for additional mask layers in semiconductor fabrication. This can result in significant cost savings and can simplify manufacturing. Secondly, enabling higher gate drive voltages for the high-side switch can reduce the $RDS_{ON}$ of the power MOSFET, leading to improved efficiency in the power conversion process. This can be particularly beneficial in high-power applications where even small efficiency improvements can result in significant energy savings and reduced thermal management requirements.

Further, the level shifter is adaptable to various SMPS configurations, providing flexibility in power management design across different voltage domains. Its ability to operate efficiently across different voltage ranges while maintaining high reliability can make it an attractive solution for a wide range of analog circuit applications requiring efficient voltage domain transfers, from portable electronics to industrial power systems. These and additional details are further detailed below.

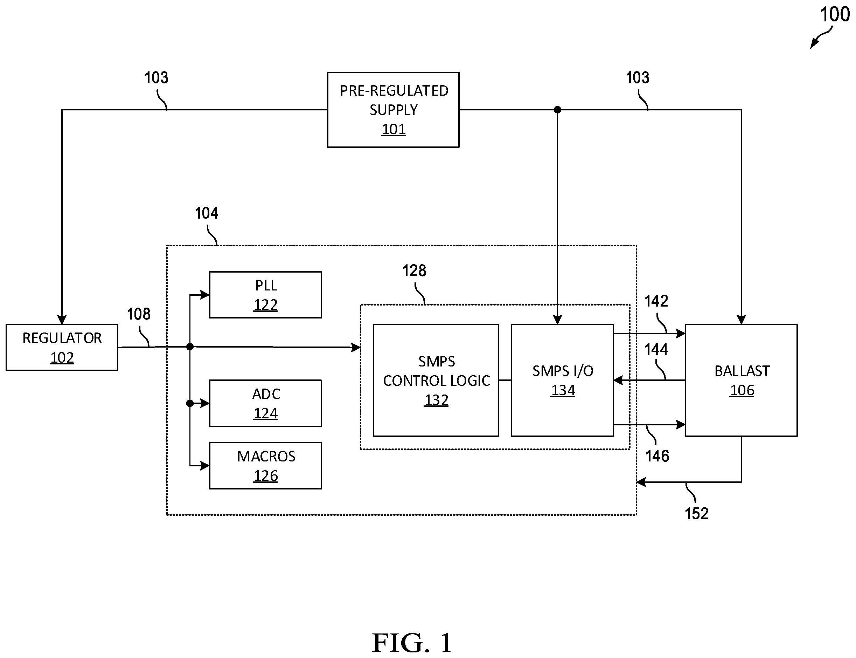

Figure 1 illustrates a simplified block diagram of an embodiment SMPS system 100 within a System on Chip (SoC). The SMPS system 100 includes a pre-regulated supply 101, a regulator 102, a SoC 104, and a ballast circuit 106, which may (or may not) be arranged as shown. SMPS system 100 may include additional components not shown, such as a controller, filters, protection circuits, and feedback circuits.

External to the SoC 104, the pre-regulated supply 101 serves as the initial power source for the SMPS system 100, providing the pre-regulated supply voltage 103 to the SMPS system 100. Generally, the pre-regulated supply voltage 103 is a high-voltage (HV) source that needs to be conditioned for use within the SoC 104.

The regulator 102 takes the pre-regulated supply voltage 103 and converts it to a stable, regulated supply voltage 108 suitable for powering the internal components of the SoC 104. The regulated supply voltage 108 is distributed to various parts of the SoC 104, including the PLL 122, the ADC 124, and macro circuits 126. Regulator 102 can be, for example, a switched-mode or linear-type regulator.

SoC 104 includes a phase-locked loop (PLL) 122, an analog-to-digital converter (ADC) 124, macro circuits 126, and a power management unit (PMU) 128, which may (or may not) be arranged as shown. It may also include additional components, such as additional PLLs and ADCs.

PLL 122 is configured to generate and synchronize clock signals for the proper timing of digital circuits within the SoC 104. The ADC 124 converts analog signals to digital format, enabling the processing of real-world inputs. The PMU 128 manages the power distribution across the SoC 104. It includes an SMPS control logic 132 and the SMPS Input/Output Interface (SMPS I/O) 134, which may (or may not) be arranged as shown. PMU 128 may include additional components not shown. SMPS control logic 132 includes, for example, monitoring circuits, a pulse-width modulator (PWM) generator circuit, and a controller (e.g., control logic circuit).

The SMPS (i.e., the SMPS control logic 132, SMPS I/O 134, and ballast circuit 106) efficiently converts voltage levels for different parts of the SMPS system 100. The SMPS I/O 134 interfaces between the SMPS control logic 132 and the ballast circuit 106.

The ballast circuit 106, typically external to the SoC, includes one or more high-side and low-side switches, an inductor, and an output capacitor. The high-side and low-side switches control the flow of current through the inductor. The switching action, governed by high-side drive signal 142 and low-side drive signal 146 supplied by SMPS control logic 132 and SMPS I/O 134, allows for efficient voltage conversion at the output of the ballast circuit 106. The switching terminal of the inductor (i.e., shared common node between the high-side switch, the low-side switch, and the inductor) is where the high-frequency switching action occurs. The feedback voltage 152, which provides feedback to the SoC 104 based on the output voltage ($V_{OUT}$), is derived from the output of the ballast circuit 106.

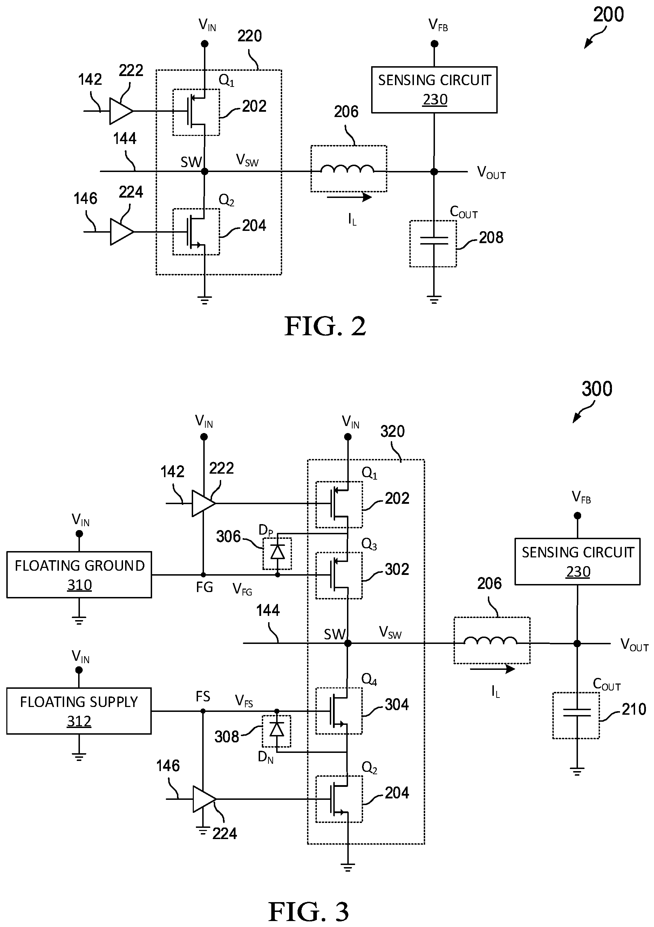

Figure 2 illustrates a schematic of an embodiment ballast circuit 200, which may be implemented as the ballast circuit 106 in Figure 1. While ballast circuit 200 is depicted as a buck converter, this is merely for illustrative purposes. The principles described in this disclosure apply to various types of power conversion circuits and are not limited to buck converters.

Ballast circuit 200 includes a switching element 220, an inductor (L) 206, an output capacitor ($C_{OUT}$) 208, a high-side driver circuit 222, and a low-side driver circuit 224, which may (or may not) be arranged as shown. Ballast circuit 200 may include additional components not shown, such as an input capacitor coupled between the input source ($V_{IN}$) and reference ground.

The switching element 220 includes a first transistor ($Q_1$) 202 (i.e., the high-side switch) and a second transistor ($Q_2$) 204 (i.e., the low-side switch). The first transistor ($Q_1$) 202 is coupled between the input source ($V_{IN}$) (the pre-regulated supply voltage 103) and the switching node (SW). The second transistor ($Q_2$) 204 is coupled between the switching node (SW) and reference ground. The first transistor ($Q_1$) 202 and the second transistor ($Q_2$) 204 can be of the metal-oxide silicon field-effect transistors (MOSFETs) type. The first transistor ($Q_1$) 202 can be a p-channel type MOSFET, and the second transistor ($Q_2$) 204 can be an n-channel type MOSFET.

The inductor (L) 206 is coupled between the switching node (SW) and an output terminal of the ballast circuit 200, typically coupled to the output capacitor ($C_{OUT}$) 208.

The SMPS control logic 132 and SMPS I/O 134 provide complementary control signals with equal duty cycles to the high-side driver circuit 222 and the low-side driver circuit 224. The output of the high-side driver circuit 222 is coupled to the gate terminal of the first transistor ($Q_1$) 202. The output of the low-side driver circuit 224 is coupled to the gate terminal of the second transistor ($Q_2$) 204.

During the ON period of the first transistor ($Q_1$) 202, the second transistor ($Q_2$) 204 is in the OFF condition, and the inductor (L) 206 is charging and providing current ($I_L$) to the output terminal of the ballast circuit 200. In contrast, during the ON period of the second transistor ($Q_2$) 204, the first transistor ($Q_1$) 202 is in the OFF condition, and the inductor (L) 206 is discharging and providing current ($I_L$) to the output terminal of the ballast circuit 200.

The sensing circuit 230, which may be implemented in the SMPS control logic 132, monitors the output voltage ($V_{OUT}$) of the ballast circuit 200 to generate a feedback voltage ($V_{FB}$). The feedback voltage (VFB) is fed to the PWM generator circuit of the SMPS control logic 132 to control the pulse widths of the complementary control signals (e.g., the high-side drive signal 142 and low-side drive signal 146), thus regulating the voltage level of the output voltage ($V_{OUT}$). In an embodiment, the sensing circuit 230 includes a resistive divider circuit.

As such, the switching node voltage ($V_{SW}$) at the switching node (SW) alternates between the voltage at the input source ($V_{IN}$) and reference ground. The controlled ON and OFF switching of the first transistor ($Q_1$) 202 and the second transistor ($Q_2$) 204 produce a fixed duty-cycle square waveform that, when filtered out by the inductor (L) 206 and output capacitor ($C_{OUT}$) 208, provides an output voltage ($V_{OUT}$) for a load, which may be provided as the feedback voltage 152 to the SoC 104. The feedback voltage 152 is at the low-power domain.

Figure 3 illustrates a schematic of an embodiment ballast circuit 300, which may be implemented as the ballast circuit 106 in Figure 1. Ballast circuit 300 is depicted as a three-level (3L) buck converter, but this is merely for illustrative purposes. The principles described in this disclosure apply to various types of power conversion circuits and are not limited to buck converters.

Ballast circuit 300 includes a switching element 320, the inductor (L) 206, the output capacitor ($C_{OUT}$) 208, the high-side driver circuit 222, the low-side driver circuit 224, a first diode ($D_P$) 306, a second diode ($D_N$) 308, a floating ground (FG) voltage generator circuit 310, and a floating supply (FS) voltage generator circuit 312, which may (or may not) be arranged as shown. Ballast circuit 200 may include additional components not shown, such as an input capacitor coupled between the input source ($V_{IN}$) and reference ground. Unless otherwise noted, previously described components with similar element numbers retain their structure and functions.

The switching element 320 includes the first transistor ($Q_1$) 202, the second transistor ($Q_2$) 204, a third transistor ($Q_3$) 302, and a fourth transistor ($Q_4$) 304. The first transistor ($Q_1$) 202 is coupled between the input source ($V_{IN}$) (the pre-regulated supply voltage 103) and the third transistor ($Q_3$) 302. The second transistor ($Q_2$) 204 is coupled between the fourth transistor ($Q_4$) 304 and reference ground. The third transistor ($Q_3$) 302 is coupled between the switching node (SW) and the first transistor ($Q_1$) 202. The fourth transistor ($Q_4$) 304 is coupled between the switching node (SW) and the second transistor ($Q_2$) 204.

The first transistor ($Q_1$) 202, the second transistor ($Q_2$) 204, the third transistor ($Q_3$) 302, and the fourth transistor ($Q_4$) 304 can be of the MOSFET type. The first transistor ($Q_1$) 202 and the third transistor ($Q_3$) 302 can be p-channel type MOSFETs. The second transistor ($Q_2$) 204 and the fourth transistor ($Q_4$) 304 can be n-channel type MOSFETs.

The cascode transistors (i.e., the third transistor ($Q_3$) 302 and the fourth transistor ($Q_4$) 304) support the operation of the ballast circuit 300 at higher voltage levels (e.g., 8 V) of the pre-regulated supply voltage 103 at the input source ($V_{IN}$).

The anode terminal of the first diode ($D_P$) 306 is coupled to the gate terminal of the third transistor ($Q_3$) 302. The cathode terminal of the first diode ($D_P$) 306 is coupled to the shared node between the drain terminal of the first transistor ($Q_1$) 202 and the source terminal of the third transistor ($Q_3$) 302.

The anode terminal of the second diode ($D_N$) 308 is coupled to the gate terminal of the fourth transistor ($Q_4$) 304. The cathode terminal of the second diode ($D_N$) 308 is coupled to the shared node between the drain terminal of the second transistor ($Q_2$) 204 and the source terminal of the fourth transistor ($Q_4$) 304.

The first diode ($D_P$) 306 and the second diode ($D_N$) 308 address reliability concerns arising from transistor leakage. For example, when the leakage of the

third transistor ($Q_3$) 302 exceeds that of the first transistor ($Q_1$) 202, the drain terminal of the first transistor ($Q_1$) 202 can discharge to an unacceptable voltage level (e.g., 0 V), comprising the reliability of the first transistor ($Q_1$) 202. The first diode ($D_P$) 306 ensures that the voltage at the source terminal of the third transistor ($Q_3$) 302 is kept at a voltage level that maintains the first transistor ($Q_1$) 202 within a safe operating region. The second diode ($D_N$) 308 performs a similar function for the second transistor ($Q_2$) 204.

The third transistor ($Q_3$) 302 is driven (i.e., biased) by a floating ground voltage ($V_{FG}$) generated by the FG voltage generator circuit 310. The fourth transistor ($Q_4$) 304 is driven by a floating supply voltage ($V_{FS}$) generated by the FS voltage generator circuit 312.

The power supply nodes of the high-side driver circuit 222 are coupled to the input source ($V_{IN}$) and the floating ground voltage ($V_{FG}$). Accordingly, the high-side driver circuit 222 functions to level shift the high-side drive signal 142 at the gate terminal of the first transistor ($Q_1$) 202 with a voltage range between the input source ($V_{IN}$) and the floating ground voltage ($V_{FG}$).

The power supply nodes of the low-side driver circuit 224 are coupled to the floating supply voltage ($V_{FS}$) and ground. Accordingly, the low-side driver circuit 224 functions to level shift the low-side drive signal 146 at the gate terminal of the second transistor ($Q_2$) 204 with a voltage range between the floating supply voltage ($V_{FS}$) and ground.

The power supply nodes of the FG voltage generator circuit 310 and the FS voltage generator circuit 312 are coupled to the input source ($V_{IN}$) and ground. The FG voltage generator circuit 310 and the FS voltage generator circuit 312 are variable voltage generator circuits where the level of the floating ground voltage ($V_{FG}$) and the floating supply voltage ($V_{FS}$) depend on the pre-regulated supply voltage 103 at the input source ($V_{IN}$) and the voltage at reference ground.

For example, over the first range of the pre-regulated supply voltage 103 at the input source ($V_{IN}$) (e.g., from 0 to 2.5 V), the level of the floating ground voltage ($V_{FG}$) tracks (i.e., follows, is substantially equal to) the voltage at the ground reference. Within the relatively lower supply voltage range of the first range, the FG voltage generator circuit 310 generates a bias voltage for the third transistor ($Q_3$) 302 such that a higher overdrive voltage is provided that allows the high-side driver circuit 222 to work reliably without exceeding the technology limits of the MOSFET safe operating area (SOA) voltages for first transistor ($Q_1$) 202 and the third transistor ($Q_3$) 302. Over a second range of the pre-regulated supply voltage 103 at the input source ($V_{IN}$) (e.g., from about 2.5 V to 8 V), the level of the floating ground voltage ($V_{FG}$) is controlled to satisfy a first ratio metric relationship dependent on the levels of the pre-regulated supply 101 and the voltage at the ground reference (e.g., the first ratio metric relationship may generally be a function of the ratio $\frac{V_{IN}-GND}{3}$ ). Within the relatively higher supply voltage range of the second range, the FG voltage generator circuit 310 generates the bias voltage for the third transistor ($Q_3$) 302 such that the first transistor ($Q_1$) 202 and the third transistor ($Q_3$) 302 do not exceed the allowed MOSFET safe operating area (SOA) voltages.

Similarly, over the first range of the pre-regulated supply voltage 103 at the input source ($V_{IN}$) (e.g., from 0 to 2.5 V), the level of the floating supply voltage ($V_{FS}$) tracks (i.e., follows, is substantially equal to) the voltage at the ground reference. Within the relatively lower supply voltage range of the first range, the FS voltage generator circuit 312 generates a bias voltage for the fourth transistor ($Q_4$) 304 such that a higher overdrive voltage is provided that allows the low-side driver circuit 224 to work reliably without exceeding the technology limits of the MOSFET safe operating area (SOA) voltages for the second transistor ($Q_2$) 204 and the fourth transistor ($Q_4$) 304. Over the second range of the pre-regulated supply voltage 103 at the input source ($V_{IN}$) (e.g., from about 2.5 V to 8 V), the level of the floating supply voltage ($V_{FS}$) is controlled to satisfy a second ratio metric relationship dependent on the levels of the pre-regulated supply 101 and the voltage at the ground reference (e.g., the second ratio metric relationship may generally be a function of the ratio $2 \times \frac{V_{IN}-GND}{3}$ ). Within the relatively higher supply voltage range of the second range, the FS voltage generator circuit 312 generates the bias voltage for the fourth transistor ($Q_4$) 304 such that the second transistor ($Q_2$) 204 and the fourth transistor ($Q_4$) 304 do not exceed the allowed MOSFET safe operating area (SOA) voltages.

The voltage level at the gate terminal of the first transistor ($Q_1$) 202 is typically higher than the voltage level at the gate terminal of the second transistor ($Q_2$) 204 to provide an efficient conversion at the ballast circuit 200. To fully turn the first transistor ($Q_1$) 202 on, its gate voltage is driven below its source voltage by a sufficient margin. Since the source terminal of the first transistor ($Q_1$) 202 is coupled to the high voltage rail, the gate drive signal must be capable of swinging to an even higher voltage to turn the first transistor ($Q_1$) 202 completely off, which necessitates a drive signal that can exceed the power supply voltage. Conversely, to turn on the second transistor ($Q_2$) 204, its gate voltage must be driven above its source voltage by a sufficient margin. Since the source terminal of the second transistor ($Q_2$) 204 is at ground potential, the gate drive signal can operate at a lower voltage level.

The need for a higher voltage at the gate terminal of the first transistor ($Q_1$) 202 creates a challenge in SMPS design. The control circuitry of the SMPS control logic 132, including the PWM generator circuit, typically operates at a lower voltage for power efficiency and compatibility with other digital systems.

The disparity between the control signal voltage and the required high-side drive voltage necessitates using a high-voltage tolerant level shifter circuit. The development of advanced integrated circuits necessitates a robust level shifter capable of facilitating voltage domain transfers at higher operating supplies. Conventional level shifters face reliability issues when pushed beyond their safe operating area (SOA) limits. For example, additional mask layers are required in the fabrication process to support higher supply voltages, increasing production costs and complexity.

Accordingly, it would be advantageous to have an efficient voltage domain transfer without incurring the additional expenses associated with extra mask layers. Such a solution would enhance the performance of integrated circuits operating across multiple voltage domains and maintain cost-effectiveness in the manufacturing process. The challenge lies in designing a level shifter that can operate reliably at higher voltages while utilizing existing low-voltage devices and standard fabrication techniques.

Aspects of the disclosure propose a high-voltage tolerant level shifter circuit that bridges the voltage gap by taking the lower-voltage control signals from the PWM generator circuit in the SMPS control logic 132 and translating them into the higher-voltage signals required to drive the first transistor ($Q_1$) 202. The level shifting is done while maintaining the timing and pulse width characteristics of the original control signal to regulate the SMPS output properly.

The proposed high-voltage tolerant level shifter circuit allows for more efficient and cost-effective SMPS designs by enabling lower-voltage control circuitry to drive higher-voltage power stages. It permits standard, lower-voltage processes for much control circuitry while enabling the ballast circuit 200 to operate at higher voltages for improved power conversion efficiency. The approach balances the need for high-voltage operation in the power stage and the benefits of lower-voltage operation in the control and logic sections of the chip.

In embodiments, a high-voltage tolerant level shifter circuit that utilizes low-voltage circuit components to operate effectively at higher supply voltages is proposed. The proposed approach offers significant advantages, particularly in mask-saving designs. By enabling low-voltage devices to function reliably in higher-voltage domains, the proposed high-voltage tolerant level shifter circuit allows for developing Intellectual Property (IP) blocks that can seamlessly transfer signals across different voltage domains while supporting higher supply operations.

Another benefit of the proposed high-voltage tolerant level shifter circuit is in its ability to reduce manufacturing costs and complexity. Traditionally, supporting higher voltage operations would require specialized high-voltage devices, necessitating additional mask layers during the semiconductor fabrication process. However, the proposed high-voltage tolerant level shifter circuit circumvents that need, allowing for standard low-voltage devices to be used even in higher-voltage applications.

The mask-saving aspect can be particularly valuable in developing analog IPs, where the ability to operate across different voltage domains is often important. The proposed high-voltage tolerant level shifter circuit can significantly reduce production costs and simplify manufacturing by eliminating the need for additional mask layers. It is an attractive solution for many analog circuit applications requiring efficient voltage domain transfers.

Further, level shifting to a higher voltage for the first transistor ($Q_1$) 202 significantly reduces its $RDS_{ON}$ (drain-to-source on-state resistance), improving the SMPS's overall efficiency. The reduction in $RDS_{ON}$ occurs because the gate-to-source voltage ($V_{GS}$) of the first transistor ($Q_1$) 202 can be driven to a higher value when operating at an elevated voltage. In a MOSFET, the channel resistance decreases as $V_{GS}$ increases beyond the threshold voltage. By level shifting the gate drive signal to a higher voltage, the circuit can apply a larger $V_{GS}$ to the high-side switch, even when its source terminal is at a high potential. The larger $V_{GS}$ more fully enhances the MOSFET channel, reducing its resistance. A lower $RDS_{ON}$ leads to reduced power dissipation in the switch during its on-state, thereby increasing the overall efficiency of the power conversion process. This is particularly beneficial in high-power applications where small efficiency improvements can result in significant energy savings and reduced thermal management requirements.

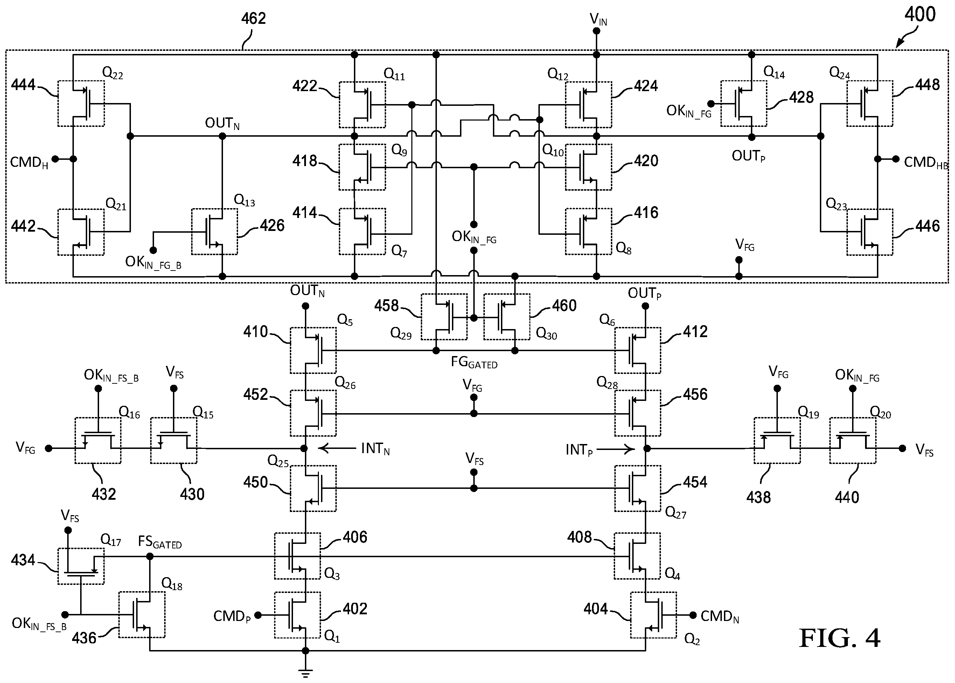

Figure 4 illustrates a schematic of an embodiment level shifter circuit 400, which may be implemented in the high-side driver circuit 222. The level shifter circuit 400 can operate within an SPMS system, such as SMPS system 100. In embodiments, level shifter circuit 400 is configured to translate (i.e., level shift) the PWM input signals ($CMD_N$ and $CMD_P$) to higher voltage output signals ($CMD_H$ and $CMD_{HB}$). The PWM input signals ($CMD_P$ and $CMD_N$) may correspond to the high-side drive signal 142 and its complementary signal.

The level shifter circuit 400 is configured to operate efficiently across different voltage ranges, depending on the pre-regulated supply voltage 103. For example, it can shift the input voltage from 5V to 8.2V or 1.8V to 3.3V at the output voltage. This flexibility makes it adaptable to various SMPS configurations while maintaining high efficiency and reliability.

Typically, when the pre-regulated supply 101 ramps up and is outside the operating range, the high-side drive signal to the gate of the high-side switch is set to OFF, and the low-side drive signal to the gate of the low-side switch is set to ON, which grounds the output voltage (core supply voltage). However, if the SMPS has not yet begun to operate and the level shifter of the high-side drive circuit is indeterminate, the high-side drive signal could remain at zero, causing the high-side switch to turn ON and bringing the output voltage up to the pre-regulated supply voltage 103.

The feedback voltage 152 is within the low-voltage supply domain. If it receives the pre-regulated supply voltage 103 at the high-voltage supply domain, it can lead to reliability issues such as device damage, compromised functionality, or permanent loss of functionality. To address this problem, it is advantageous for the level shifter circuit 400 to adopt a definite state before the system starts operating (e.g., before the SMPS loop begins working) or if the input supply is not within the appropriate range for the proper level shifter operation.

Control signals $OK_{IN\_FG}$ and $OK_{IN\_FS}$ (and their complementary signals $OK_{IN\_FG\_B}$ and $\overline{OK}_{IN\_FS\_B}$) are provided by, for example, a separate monitor circuit. The control signals ensure the level shifter circuit 400 operates within a known state by indicating the status of the pre-regulated supply voltage 103 at the input source (VIN).

The ninth transistor ($Q_9$), the tenth transistor ($Q_{10}$) 420, the thirteenth transistor ($Q_{13}$) 426, the fourteenth transistor ($Q_{14}$) 428, the twenty-ninth transistor ($Q_{29}$) 458, and the thirtieth transistor ($Q_{30}$) 460 are controlled by the control signals $OK_{IN}$.

For example, if the control signal $OK_{IN\_FG}$ is at logic low, indicating that the floating ground voltage ($V_{FG}$) is outside the safe operating region, transistors the ninth transistor ($Q_9$) and the tenth transistor ($Q_{10}$) 420 are turned OFF. The fourteenth transistor ($Q_{14}$) 428 turns ON, pulling intermediate output $OUT_P$ to the pre-regulated supply voltage 103. Similarly, thirteenth transistor ($Q_{13}$) 426 turns ON, bringing intermediate output $OUT_N$ to the floating ground voltage ($V_{FG}$). Hence, in the absence of the pre-regulated supply voltage 103 or when the input source ($V_{IN}$) is outside a safe operating region, the output signals $CMD_H$ and $CMD_{HB}$ of the level shifter circuit 400 default to a known state (e.g., a logic high at $CMD_H$ and a logic low at $CMD_{HB}$). Conversely, in level shifter circuit 500, as further detailed below, this would result in setting $CMD_H$ to a logic low and $CMD_{HB}$ to a logic high.

Accordingly, level shifter circuit 400 can maintain safe operation across different voltage domains. For example, when the pre-regulated supply voltage 103 is unavailable or outside the proper range, the control signals ensure that the level shifter circuit 400 transitions to a known, safe state. This prevents stress on the transistors and maintains reliability.

The input signals $CMD_N$ and $CMD_P$ are complementary PWM signals generated by the PWM generator circuit of the SMPS control logic 132. These low-voltage signals carry the switching information necessary to control the SMPS operation. The input signals $CMD_P$ (Command Positive) and $CMD_N$ (Command Negative) are always in opposite states-when one is high, the other is low. The duty cycle of these signals determines the output voltage of the SMPS. The level shifter circuit 400 takes these input signals and translates them to higher voltage levels, $CMD_H$ and $CMD_{HB}$, respectively.

In embodiments, the output signal $CMD_H$ is coupled to the gate terminal of the high-side transistor, such as the first transistor ($Q_1$) 202, accommodating different voltage domains based on the pre-regulated supply voltage 103.

In an SMPS with a differential control at the high-side switch, the output signals $CMD_H$ and $CMD_{HB}$ are the differential signals for the high-side switch, which are simultaneously available. The level shifting allows the SMPS control logic 132 to manage the higher-voltage power components of the SMPS.

The level shifter circuit 400 incorporates several voltage inputs, including the floating ground voltage ($V_{FG}$) and the floating supply voltage ($V_{FS}$). The floating supply voltage ($V_{FS}$) and the floating ground voltage ($V_{FG}$) act as cascode voltages, protecting n-type and p-type transistors from exceeding their voltage limits.

The floating ground voltage ($V_{FG}$) is dynamically generated based on the voltage level of the pre-regulated supply voltage 103 at the input source ($V_{IN}$) to be substantially at the same potential as reference ground in a lower first range and symmetric to the pre-regulated supply voltage 103 at a higher second range. In embodiments, the floating ground voltage ($V_{FG}$) is generated by a dedicated voltage generator circuit, such as the FG voltage generator circuit 310. In embodiments, a resistor divider network generates the floating ground voltage ($V_{FG}$). In embodiments, the floating supply voltage ($V_{FS}$) is generated by a dedicated voltage generator circuit, such as the FS voltage generator circuit 312. In embodiments, a resistor divider network generates the floating supply voltage ($V_{FS}$).

Depending on the logic level of the input signals $CMD_P$ and $CMD_N$, either the left or right sides of the level shifter circuit 400 turns ON, while the other side turns OFF. For example, if $CMD_P$ is at a logic high and $CMD_N$ is at a logic low, the second branch (which includes the second transistor ($Q_2$) 404, the fourth transistor ($Q_4$) 408, the sixth transistor ($Q_6$) 412, the twenty-seventh transistor ($Q_{27}$) 454, and the twenty-eighth transistor ($Q_{28}$) 456) turns OFF and the first branch (which includes first transistor ($Q_1$) 402, the third transistor ($Q_3$) 406, the fifth transistor ($Q_5$) 410, the twenty-fifth transistor ($Q_{25}$) 450, and the twenty-sixth transistor ($Q_{26}$) 452) turns ON.

The first branch will sink current, causing the intermediate output $OUT_N$ to fall to the floating ground voltage ($V_{FG}$) through the latch formed by the seventh transistor ($Q_7$) 414, the ninth transistor ($Q_9$), and the eleventh transistor ($Q_{11}$) 422. Meanwhile, the intermediate $OUT_P$ for the second branch will rise to the level of the pre-regulated supply voltage 103 through the fourteenth transistor ($Q_{14}$) 428-tracking the logic of the input signals $CMD_P$ and CMDN.

The first transistor ($Q_1$) 402 and the second transistor ($Q_2$) 404 sense the input signals $CMD_N$ and $CMD_P$, respectively. These transistors generate a differential current that drives a latch formed by the seventh transistor ($Q_7$) 414, the eighth transistor ($Q_8$) 416, the

ninth transistor ($Q_9$) 418, the tenth transistor ($Q_{10}$) 420, the eleventh transistor ($Q_{11}$) 422, and the twelfth transistor ($Q_{12}$) 424. The latch's state corresponds to the input signals $CMD_N$ and $CMD_P$, translating the low-voltage inputs to the higher-voltage domain required for the output.

The voltage output signals $CMD_H$ and $CMD_{HB}$ are the primary complementary outputs configured to drive the high-side switch in the SMPS. The internal voltages $INT_N$ and $INT_P$ provide rail-to-rail differential outputs capable of driving a low-side switch of the SMPS if required. Intermediate outputs $OUT_N$ and $OUT_P$ serve latching purposes but are not essential to the primary function of level shifter circuit 400.

The third transistor ($Q_3$) 406, the fourth transistor ($Q_4$) 408, the twenty-fifth transistor ($Q_{25}$) 450, and the twenty-seventh transistor ($Q_{27}$) 454 are arranged in a cascode configuration, providing protection to the input transistors (i.e., the first transistor ($Q_1$) 402 and the second transistor ($Q_2$) 404).

The upper portion 462 of the level shifter circuit 400 operates between the pre-regulated supply voltage 103 at the input source ($V_{IN}$) and the floating ground voltage ($V_{FG}$)-intermediate ground. The fifth transistor ($Q_5$) 410, the sixth transistor ($Q_6$) 412, the twenty-sixth transistor ($Q_{26}$) 452, and the twenty-eighth transistor ($Q_{28}$) 456 are arranged in a cascode configuration, providing protection to the upper portion 462 of the level shifter circuit 400.

The various p-channel and n-channel MOSFETs of the level shifter circuit 400 operate in the low-power domain, which saves an extra masking step required when transistors in a circuit operate at different power domains (e.g., low and high-power domains).

In embodiments, the first transistor ($Q_1$) 402, the second transistor ($Q_2$) 404, the third transistor ($Q_3$) 406, the fourth transistor ($Q_4$) 408, the ninth transistor ($Q_9$), the tenth transistor ($Q_{10}$) 420, the thirteenth transistor ($Q_{13}$) 426, the fifteenth transistor ($Q_{15}$) 430, the sixteenth transistor ($Q_{16}$) 432, the eighteenth transistor (Q18) 436, the twenty-first transistor ($Q_{21}$) 452, the twenty-third transistor ($Q_{23}$) 446, the twenty-fifth transistor ($Q_{25}$) 450, and the twenty-seventh transistor ($Q_{27}$) 454 are n-channel MOSFETs.

In embodiments, the fifth transistor ($Q_5$) 410, the sixth transistor ($Q_6$) 412, the seventh transistor ($Q_7$) 414, the eighth transistor ($Q_8$) 416, the eleventh transistor ($Q_{11}$) 422, the twelfth transistor ($Q_{12}$) 424, the fourteenth transistor ($Q_{14}$) 428, the seventeenth transistor ($Q_{17}$) 434, the nineteenth transistor ($Q_{19}$) 438, the twentieth transistor ($Q_{20}$) 440, the twenty-second transistor ($Q_{22}$) 454, the twenty-fourth transistor ($Q_{24}$) 448, the twenty-sixth transistor ($Q_{26}$) 452, the twenty-eighth transistor ($Q_{28}$) 456, the twenty-ninth transistor ($Q_{29}$) 458, and the thirtieth transistor ($Q_{30}$) 460 are p-channel MOSFETs.

The first transistor ($Q_1$) 402 has a gate terminal coupled to the PWM input signal ($CMD_P$). The source terminal of the first transistor ($Q_1$) 402 is coupled to the reference ground. The drain terminal of the first transistor ($Q_1$) 402 is coupled to the source terminal of the third transistor ($Q_3$) 406.

The second transistor ($Q_2$) 404 has a gate terminal coupled to the PWM input signal ($CMD_N$). The source terminal of the second transistor ($Q_2$) 404 is coupled to the reference ground. The drain terminal of the second transistor ($Q_2$) 404 is coupled to the source terminal of the fourth transistor ($Q_4$) 408.

The gate terminals of the third transistor ($Q_3$) 406 and the fourth transistor ($Q_4$) 408 are coupled to the source terminal of the seventeenth transistor ($Q_{17}$) 434 and the drain terminal of the eighteenth transistor (Q18) 436, which provides the $FS_{GATED}$ signal. The drain terminal of the third transistor ($Q_3$) 406 is coupled to the drain terminal of the twenty-fifth transistor ($Q_{25}$) 450. The drain terminal of the fourth transistor ($Q_4$) 408 is coupled to the drain terminal of the twenty-seventh transistor ($Q_{27}$ 454.

The gate terminals of the fifth transistor ($Q_5$) 410 and the sixth transistor ($Q_6$) 412 are coupled to the $FG_{GATED}$ signal. The source terminal of the fifth transistor ($Q_5$) 410 is coupled to the intermediate output $OUT_N$. The drain terminal of the fifth transistor ($Q_5$) 410 is coupled to the source terminal of the twenty-sixth transistor ($Q_{26}$) 452.

The source terminal of the sixth transistor ($Q_6$) 412 is coupled to the intermediate output $OUT_P$. The drain terminal of the sixth transistor ($Q_6$) 412 is coupled to the source terminal of the twenty-eighth transistor ($Q_{28}$) 456.

The seventh transistor ($Q_7$) 414 has a gate terminal coupled to the gate terminals of the eleventh transistor ($Q_{11}$) 422, the twenty-third transistor ($Q_{23}$) 446, and the twenty-fourth transistor ($Q_{24}$) 448, and the drain terminals of the tenth transistor ($Q_{10}$) 420 and the twelfth transistor ($Q_{12}$) 424, which are coupled to the intermediate output $OUT_P$. The source terminal of the seventh transistor ($Q_7$) 414 is coupled to the source terminal of the ninth transistor ($Q_9$) 418. The drain terminal of the seventh transistor ($Q_7$) 414 is coupled to the floating ground voltage ($V_{FG}$). The ninth transistor ($Q_9$) 418 has a gate terminal coupled to the gate terminal of the tenth transistor ($Q_{10}$) 420, which is coupled to the $OK_{IN\_FG}$ signal. The source terminal of the eleventh transistor ($Q_{11}$) 422 is coupled to the input source ($V_{IN}$).

The eighth transistor ($Q_8$) 416 has a gate terminal coupled to the gate terminals of the twelfth transistor ($Q_{12}$) 424, the twenty-first transistor ($Q_{21}$) 442, and the twenty-second transistor ($Q_{22}$) 454, and the drain terminals of the ninth transistor ($Q_9$) 418 and the eleventh transistor ($Q_{11}$) 422, which are coupled to the intermediate output $OUT_N$. The source terminal of the eighth transistor ($Q_8$) 416 is coupled to the source terminal of the tenth transistor ($Q_{10}$) 420. The drain terminal of the eighth transistor ($Q_8$) 416 is coupled to the floating ground voltage ($V_{FG}$). The source terminal of the twelfth transistor ($Q_{12}$) 424 is coupled to the input source (VIN).

The thirteenth transistor ($Q_{13}$) 426 has a gate terminal coupled to the control signal $OK_{IN\_FG\_B}$. The source terminal of the thirteenth transistor ($\overline{Q13}$) 426 is coupled to the intermediate output $OUT_N$. The drain terminal of the thirteenth transistor ($Q_{13}$) 426 is coupled to the floating ground voltage ($V_{FG}$).

The fourteenth transistor ($Q_{14}$) 428 has a gate terminal coupled to the control signal $OK_{IN\_FG}$, which is complementary to the control signal $OK_{IN\_FG\_B}$. The source terminal of the fourteenth transistor ($\overline{OK_{IN\_FG\_B}}$ signal) 428 is coupled to the input source ($V_{IN}$). The drain terminal of the fourteenth transistor ($Q_{14}$) 428 is coupled to the intermediate output $OUT_P$.

The fifteenth transistor ($Q_{15}$) 430 has a gate terminal coupled to the floating supply voltage ($V_{FS}$). The source terminal of the fifteenth transistor ($Q_{15}$) 430 is coupled to the drain terminal of the sixteenth transistor ($Q_{16}$) 432. The drain terminal of the fifteenth transistor ($Q_{15}$) 430 is coupled to the drain terminals of the twenty-fifth transistor ($Q_{25}$) 450 and the twenty-sixth transistor ($Q_{26}$) 452, which provide the internal voltage $INT_N$. The sixteenth transistor ($Q_{16}$) 432 has a gate terminal coupled to the control signal $OK_{IN\_FS\_B}$. The source terminal of the sixteenth transistor ($Q_{16}$) 432 is coupled to the floating ground voltage ($V_{FG}$).

The seventeenth transistor ($Q_{17}$) 434 has a gate terminal coupled to the gate terminal of the eighteenth transistor ($Q_{18}$) 436, which receives the control signal $OK_{IN\_FS\_B}$. The drain terminal of the seventeenth transistor ($Q_{17}$) 434 is coupled to the floating supply voltage ($V_{FS}$). The source terminal of the eighteenth transistor (Q18) 436 is coupled to the floating ground voltage (VFG). The drain terminal of the eighteenth transistor (Q18) 436 is coupled to the $FS_{GATED}$ signal.

The seventeenth transistor ($Q_{17}$) 434 and the eighteenth transistor (Q18) 436 form a first CMOS inverter-like structure that generates the $FS_{GATED}$ signal based on the state of the control signal $OK_{IN\_FS\_B}$.

The nineteenth transistor ($Q_{19}$) 438 has a gate terminal coupled to the floating ground voltage ($V_{FG}$). The source terminal of the nineteenth transistor ($Q_{19}$) 438 is coupled to the drain terminals of the twenty-eighth transistor ($Q_{28}$) 456 and the twenty-seventh transistor ($Q_{27}$) 454, which provide the internal voltages $INT_P$. The drain terminal of the nineteenth transistor ($Q_{19}$) 438 is coupled to the source terminal of the twentieth transistor ($Q_{20}$) 440. The twentieth transistor ($Q_{20}$) 440 has a gate terminal coupled to the control signal $OK_{IN\_FG}$, which is complementary to the control signal $OK_{IN\_FG\_B}$. The drain terminal of the twentieth transistor ($Q_{20}$) 440 is coupled to the floating supply voltage ($V_{FS}$).

The source terminals of the twenty-first transistor ($Q_{21}$) 442 and the twenty-third transistor ($Q_{23}$) 446 are coupled to the floating ground voltage ($V_{FG}$). The source terminals of the twenty-second transistor ($Q_{22}$) 444 and the twenty-fourth transistor ($Q_{24}$) 448 are coupled to the input source ($V_{IN}$). The drain terminal of the twenty-first transistor ($Q_{21}$) 442 is coupled to the drain terminal of the

twenty-second transistor ($Q_{22}$) 444, which provides the output signal $CMD_H$. The drain terminal of the twenty-third transistor ($Q_{23}$) 446 is coupled to the drain terminal of the twenty-fourth transistor ($Q_{24}$) 448, which provides the output signal $CMD_{HB}$, which is a complementary signal to the output signal $CMD_H$.

In embodiments, the twenty-first transistor ($Q_{21}$) 442, twenty-second transistor ($Q_{22}$) 444, the twenty-third transistor ($Q_{23}$) 446, and the twenty-fourth transistor ($Q_{24}$) 448 are optional and provide buffering.

The gate terminals of the twenty-fifth transistor ($Q_{25}$) 450 and the twenty-seventh transistor ($Q_{27}$) 454 are coupled to the floating supply voltage ($V_{FS}$). The control terminals of the twenty-sixth transistor ($Q_{26}$) 452 and the twenty-eighth transistor ($Q_{28}$) 456 are coupled to the floating ground voltage ($V_{FG}$).

The gate terminals of the twenty-ninth transistor ($Q_{29}$) 458 and the thirtieth transistor ($Q_{30}$) 460 are coupled to the control signal $OK_{IN\_FG}$. The drain terminals of the twenty-ninth transistor ($Q_{29}$) 458 and the thirtieth transistor ($Q_{30}$) 460 are coupled to the $FG_{GATED}$ signal. The source terminal of the twenty-ninth transistor ($Q_{29}$) 458 is coupled to the input source ($V_{IN}$). The source terminal of the thirtieth transistor ($Q_{30}$) 460 is coupled to the floating ground voltage ($V_{FG}$).

The twenty-ninth transistor ($Q_{29}$) 458 and the thirtieth transistor ($Q_{30}$) 460 form a second CMOS inverter-like structure that produces the $FG_{GATED}$ signal based on the state of the control signal $OK_{IN\_FG}$.

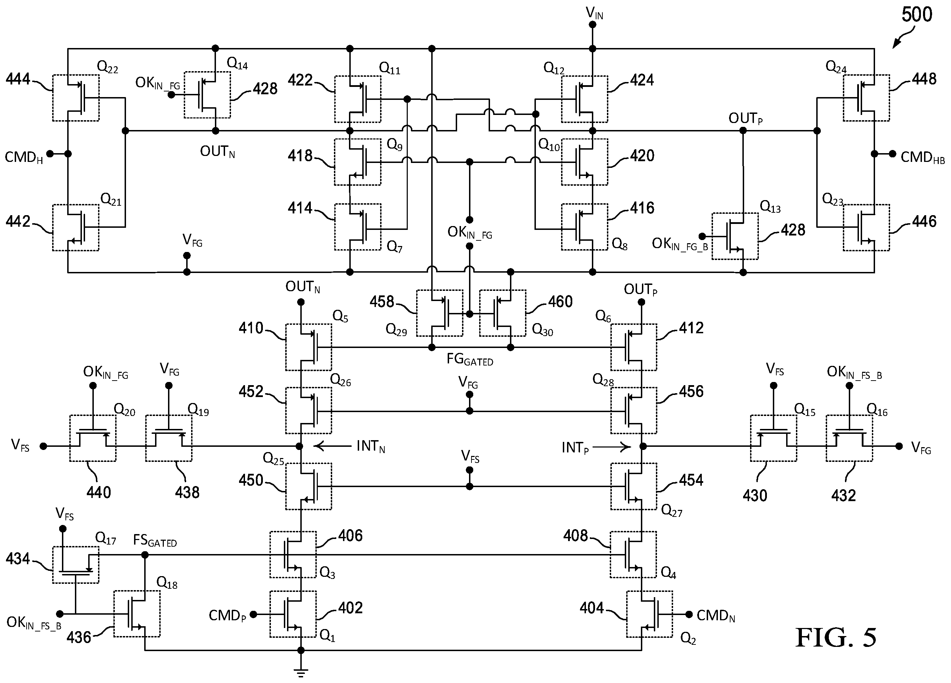

Figure 5 illustrates a schematic of an embodiment of a level shifter circuit 500, which can be implemented in the high-side driver circuit 222. The level shifter circuit 500 functions similarly to the previously described level shifter circuit 400 and shares many components and arrangements. To avoid redundancy, the following discussion will focus on the key differences between level shifter circuit 500 and level shifter circuit 400.

The level shifter circuit 500 modifies the safe state behavior compared to the level shifter circuit 400. While the level shifter circuit 400 is configured to default to a set type safe state, represented by a logic 1, the level shifter circuit 500 implements a reset type safe state, corresponding to a logic 0. The default safe state logic level change distinguishes between the two embodiments of the level shifter circuits, affecting how each behaves during power-up, shut down, or other transitional states. The modification may offer advantages in certain applications where a logic 0 safe state is preferred or required for system stability or compatibility with other components.

The first difference is the arrangement of the thirteenth transistor ($Q_{13}$) 426. In level shifter circuit 500, the drain terminal of the thirteenth transistor ($Q_{13}$) 426 is coupled to the intermediate output $OUT_P$, whereas in level shifter circuit 400, the drain terminal of the thirteenth transistor ($Q_{13}$) 426 is coupled to the intermediate output $OUT_N$.

A second difference is the arrangement of the fourteenth transistor ($Q_{14}$) 428. In level shifter circuit 500, the drain terminal of the fourteenth transistor ($Q_{14}$) 428 is coupled to the intermediate output $OUT_N$, whereas in level shifter circuit 400, the drain terminal of the fourteenth transistor ($Q_{14}$) 428 is coupled to the intermediate output $OUT_P$.

The third difference is the arrangement of the fifteenth transistor ($Q_{15}$) 430. In level shifter circuit 500, the drain terminal of the fifteenth transistor ($Q_{15}$) 430 is coupled to the internal voltage $INT_P$, whereas in level shifter circuit 400, the drain terminal of the fifteenth transistor ($Q_{15}$) 430 is coupled to the internal voltage $INT_N$.

The fourth difference is the arrangement of the nineteenth transistor ($Q_{19}$) 438. In level shifter circuit 500, the drain terminal of the nineteenth transistor ($Q_{19}$) 438 is coupled to the internal voltage $INT_N$, whereas in level shifter circuit 400, the drain terminal of the nineteenth transistor ($Q_{19}$) 438 is coupled to the internal voltage $INT_P$.

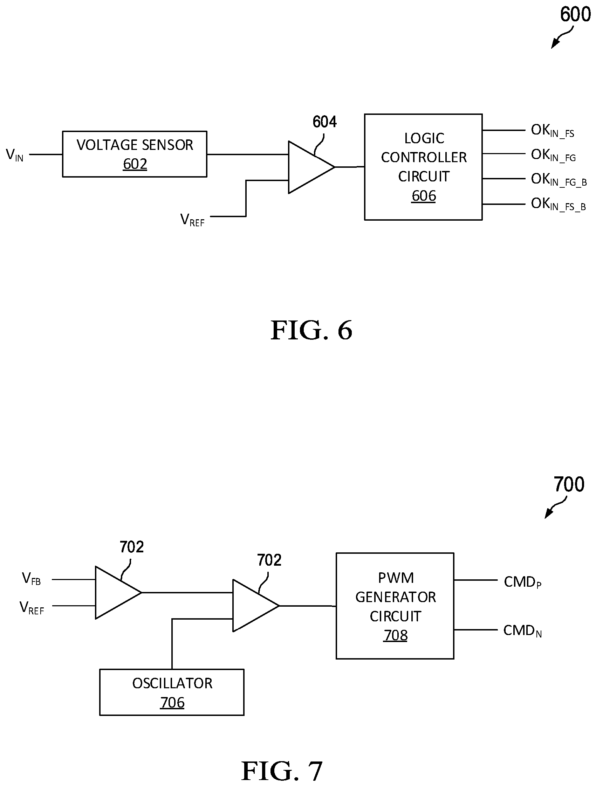

Figure 6 illustrates a block diagram of an embodiment monitoring circuit 600. In embodiments, monitoring circuit 600 is configured to generate the control signals $OK_{IN\_FG}$ and $OK_{IN\_FS}$ and their complementary signals $OK_{IN\_FG\_B}$ and $OK_{IN\_FS\_B}$.

Monitoring circuit 600 includes a voltage sensor 602, a comparator 604, and a control logic circuit 606, which may (or may not) be arranged as shown. Monitoring circuit 600 may include additional components not shown.

Monitoring circuit 600 monitors the pre-regulated supply voltage 103 and ensures that the level shifter circuit 400 operates within a known, safe state. The monitoring circuit 600 evaluates whether the pre-regulated supply voltage 103 at the input source ($V_{IN}$) is within the proper operating range for the level shifter circuit 400 or level shifter circuit 500. When the pre-regulated supply voltage 103 is outside this range, the control signals $OK_{IN}$ transition to a state that puts the level shifter circuit 400 or level shifter circuit 500 into a safe mode, preventing stress on the transistors and maintaining reliability. When the pre-regulated supply voltage 103 returns to the proper range, the control signals $OK_{IN}$ change state to allow normal operation of the level shifter circuit 400.

Voltage sensor 602 is configured to measure the pre-regulated supply voltage 103. In an embodiment, it includes a voltage divider network or a sensing circuit to scale the input voltage to a level suitable for comparison. The voltage sensor 602 is coupled to the input source ($V_{IN}$) and provides its output to an input of the comparator 604. It continuously monitors the input source ($V_{IN}$), providing a proportional and scaled representation of pre-regulated supply voltage 103 for further processing.

The comparator 604 can be an analog circuit that compares the output of the voltage sensor 602 with a reference voltage ($V_{REF}$), which is a stable, precise voltage source that is a benchmark for comparison against the sensed pre-regulated supply voltage 103 to determine if the input source ($V_{IN}$) is within the proper operating range.

Comparator 604 may be implemented as an operational amplifier configured for comparison or a dedicated comparator integrated circuit. It is coupled to the output of the voltage sensor 602 and the reference voltage ($V_{REF}$) and fed into the control logical circuit 606. Comparator 604 can determine whether the sensed pre-regulated supply voltage 103 is above or below the reference voltage ($V_{REF}$), outputting, for example, a binary signal that indicates the relative state of the input source ($V_{IN}$).

The control logic circuit 606 can be a digital or mixed-signal circuit that processes the output from the comparator 604 and generates the appropriate control signals $OK_{IN}$ (i.e., $OK_{IN\_FG}$, $OK_{IN\_FS}$, $OK_{IN\_FG\_B}$, and $OK_{IN\_FS\_B}$). It may include flip-flops, logic gates, or a small microcontroller. The control logic circuit 606 is coupled to the output of the comparator 604 and provides the control signals $OK_{IN}$ as outputs to the level shifter circuit 400.

Figure 7 illustrates a block diagram of an embodiment SMPS control logic 700, which may be implemented as the SMPS control logic 132 in Figure 1. In embodiments, SMPS control logic 700 is configured to generate the high-side drive signal 142 and low-side drive signal 146. In embodiments, SMPS control logic 700 is configured to generate the PWM input signals ($CMD_N$ and $CMD_P$) that are fed to the level shifter circuit 400.

As shown, SMPS control logic 700 includes an error amplifier 702, a PWM comparator 704, an oscillator 706, and a PWM generator circuit 708, which may (or may not) be arranged as shown. SMPS control logic 700 may include additional components that are not shown, such as an over-current protection circuit, a thermal shutdown circuit, and a control logic and protection circuit for safe operation.

The error amplifier 702 can be an operational amplifier circuit configured to compare the feedback voltage ($V_{FB}$) from the sensing circuit 230 with a second reference voltage ($V_{REF}$). The error amplifier 702 amplifies the difference between these two inputs to generate an error signal. It provides its output to the PWM comparator 704. The error amplifier 702 continuously monitors the feedback voltage ($V_{FB}$) to generate a control signal representing the deviation from the desired voltage level to maintain voltage regulation in the SMPS.

The PWM comparator 704 can be a high-speed comparator circuit configured to compare the error signal from the error amplifier 702 with a periodic waveform (typically a sawtooth or triangle wave) generated by the oscillator 706. The PWM comparator 704 is coupled to the output of the error amplifier 702 and the output of the oscillator 706. The output of the PWM comparator 704 feeds into the PWM generator circuit 708. The PWM comparator 704 generates a pulse-width modulated signal based on the intersection of the error signal and the oscillator waveform, which forms the basis for controlling the duty cycle of the SMPS switches.

The oscillator 706 can be a circuit that generates a stable, periodic waveform, typically a sawtooth or triangle wave. It can be implemented using, for example, a relaxation oscillator circuit or a more precise crystal-based oscillator with additional waveshaping. The oscillator 706 is coupled to the PWM comparator 704 and other timing circuits (not shown) within the SMPS control logic 700. It provides a consistent time base for the PWM generation, determining the switching frequency of the SMPS and ensuring stable operation.

The PWM generator circuit 708 can be a logic circuit that takes the output from the PWM comparator 704 and generates the complementary PWM signals $CMD_P$ and $CMD_N$. It may include flip-flops, logic gates, and potentially dead-time insertion circuitry. The PWM generator circuit 708 is coupled to the output of the PWM comparator 704 and provides the $CMD_P$ and $CMD_N$ signals as outputs to the level shifter circuit 400. Its function is to create properly timed, non-overlapping control signals for the high-side and low-side switches of the SMPS, ensuring efficient and safe switching operation.

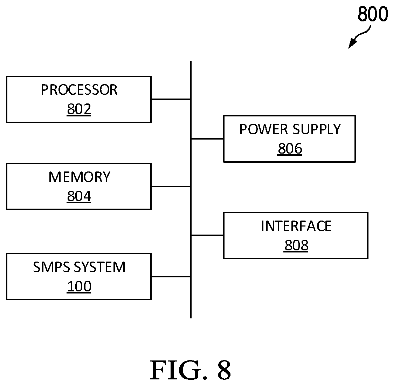

Figure 8 illustrates a block diagram of an embodiment system 800. System 800 includes a processor 802, a memory 804, the SMPS system 100, a power supply 806, and an interface 808, which may (or may not) be arranged as shown. System 800 may include additional components not shown, such as long-term storage (e.g., non-volatile memory, etc.), a bus system (i.e., control, status, data, etc. bus) to couple the various components of the device, security and encryption modules (e.g., trusted platform modules (TPM), etc.), or the like.

In embodiments, system 800 is an electronic device, such as a mobile device, a computing device, a consumer electronic, an automotive electronic, an industrial and internet-of-things (IoT) type device, a telecommunication equipment, a medical device, an aerospace and defense device, a test and measuring equipment, or the like.

Although one of each (i.e., the processor 802, the memory 804, the SMPS system 100, the power supply 806, and the interface 808) is shown in Figure 8, the number of components is not limiting, and greater numbers are similarly contemplated in other embodiments.

Processor 802 may be any component or collection of components adapted to perform computations or other processing-related tasks. In embodiments, processor 802 is an application processor, a microcontroller, a digital signal processor, a graphics processing unit, or a combination thereof.

Memory 804 may be any component or collection of components adapted to store programming or instructions for execution by processor 802. In an embodiment, memory 804 includes a non-transitory computer-readable medium.

Power supply 806 provides a power source for operating the system 800. In embodiments, it is implemented as the pre-regulated supply 101 to provide the pre-regulated supply voltage 103 to the SMPS system 100.

SMPS system 100 is configured to receive the pre-regulated supply voltage from the power supply 806 and generate a regulated output voltage using the level shifter circuit 400 to drive the high-side switch of the SMPS. The regulated output voltage from the SMPS system 100 may be used to operate various components internal or external to system 800.

Interface 808 may be any component or collection of components that allow processor 802 to communicate with other devices/components or a user. For example, interface 808 may be adapted to receive wireless power from an external source using a transceiver circuit and antennas. Further, interface 808 may include circuitry that allows system 800 to communicate signals externally or internally within the system 800 or a user.

A first aspect relates to a high-voltage tolerant level shifter circuit. The high-voltage tolerant level shifter circuit comprises a first input terminal configured to receive a first pulse-width modulation (PWM) input signal; a second input terminal configured to receive a second PWM input signal complementary to the first PWM input signal; a first output terminal configured to provide a first output signal; a second output terminal configured to provide a second output signal complementary to the first output signal; a latch circuit coupled between the first input terminal and the first output terminal and between the second input terminal and the second output terminal, the latch circuit configured to translate the first PWM input signal and the second PWM input signal to the first output signal and the second output signal; a floating ground voltage input terminal configured to receive a floating ground voltage; a floating supply voltage input terminal configured to receive a floating supply voltage; and a control circuit coupled to the latch circuit and configured to receive control signals to ensure the high-voltage tolerant level shifter circuit operates within a known state.

In a first implementation form of the high-voltage tolerant level shifter circuit, according to the first aspect as such, the latch circuit includes a first pair of cross-coupled p-channel metal-oxide-semiconductor (PMOS) transistors and a second pair of cross-coupled n-channel metal-oxide-semiconductor (NMOS) transistors. In a second implementation form of the high-voltage tolerant level shifter circuit, according to the first aspect as such or any preceding implementation form of the first aspect, the high-voltage tolerant level shifter circuit further includes a first n-channel metal-oxide-semiconductor (NMOS) transistor having a gate terminal coupled to the first input terminal; a second NMOS transistor having a gate terminal coupled to the second input terminal; a third NMOS transistor coupled between the first NMOS transistor and the latch circuit; and a fourth NMOS transistor coupled between the second NMOS transistor and the latch circuit.

In a third implementation form of the high-voltage tolerant level shifter circuit, according to the first aspect as such or any preceding implementation form of the first aspect, a gate terminal of the third NMOS transistor and a gate terminal of the fourth NMOS transistor are coupled to receive a gated floating supply voltage.

In a fourth implementation form of the high-voltage tolerant level shifter circuit, according to the first aspect as such or any preceding implementation form of the first aspect, the floating ground voltage and the floating supply voltage are generated based on a pre-regulated supply voltage.

In a fifth implementation form of the high-voltage tolerant level shifter circuit, according to the first aspect as such or any preceding implementation form of the first aspect, over a first range of the pre-regulated supply voltage, the floating ground voltage tracks a reference ground voltage. Over a second range of the pre-regulated supply voltage, the floating ground voltage is controlled to satisfy a first ratio metric relationship dependent on the pre-regulated supply voltage and the reference ground voltage.

In a sixth implementation form of the high-voltage tolerant level shifter circuit, according to the first aspect as such or any preceding implementation form of the first aspect, over a first range of the pre-regulated supply voltage, the floating supply voltage tracks a reference ground voltage, and over a second range of the pre-regulated supply voltage, the floating supply voltage is controlled to satisfy a second ratio metric relationship dependent on the pre-regulated supply voltage and the reference ground voltage.

A second aspect relates to a level shifter system comprising a high-voltage tolerant level shifter circuit including a first input terminal configured to receive a first pulse-width modulation (PWM) input signal, a second input terminal configured to receive a second PWM input signal complementary to the first PWM input signal, a first output terminal configured to provide a first output signal, a second output terminal configured to provide a second output signal complementary to the first output signal, a latch circuit coupled between the first input terminal and the first output terminal and between the second input terminal and the second output terminal, the latch circuit configured to translate the first PWM input signal to the first output signal, a floating ground voltage input terminal, a floating supply voltage input terminal, and a control circuit coupled to the latch circuit and configured to receive control signals to ensure the high-voltage tolerant level shifter circuit operates within a known state. The level shifter system comprises a floating ground voltage generator circuit coupled to the floating ground voltage input terminal and configured to generate a floating ground voltage; and a floating supply voltage generator circuit coupled to the floating supply voltage input terminal and configured to generate a floating supply voltage.

**In** a first implementation form of the level shifter system, according to the second aspect as such, the level shifter system further includes a monitoring circuit configured to generate the control signals based on a pre-regulated supply voltage. **In** a second implementation form of the level shifter system, according to the second aspect as such or any preceding implementation form of the second aspect, the monitoring circuit includes a voltage sensor configured to measure the pre-regulated supply voltage; a comparator coupled to the voltage sensor and configured to compare an output of the voltage sensor with a reference voltage; and a control logic circuit coupled to the comparator and configured to generate the control signals based on an output of the comparator.

**In** a third implementation form of the level shifter system, according to the second aspect as such or any preceding implementation form of the second aspect, the latch circuit includes a first pair of cross-coupled p-channel metal-oxide-semiconductor (PMOS) transistors and a second pair of cross-coupled n-channel metal-oxide-semiconductor (NMOS) transistors.

**In** a fourth implementation form of the level shifter system, according to the second aspect as such or any preceding implementation form of the second aspect, the high-voltage tolerant level shifter circuit further comprises a first n-channel metal-oxide-semiconductor (NMOS) transistor having a gate terminal coupled to the first input terminal; a second NMOS transistor having a gate terminal coupled to the second input terminal; a third NMOS transistor coupled between the first NMOS transistor and the latch circuit; and a fourth NMOS transistor coupled between the second NMOS transistor and the latch circuit.

**In** a fifth implementation form of the level shifter system, according to the second aspect as such or any preceding implementation form of the second aspect, a gate terminal of the third NMOS transistor and a gate terminal of the fourth NMOS transistor are coupled to receive a gated floating supply voltage derived from the floating supply voltage.

In a sixth implementation form of the level shifter system, according to the second aspect as such or any preceding implementation form of the second aspect, over a first range of a pre-regulated supply voltage, the floating ground voltage tracks a reference ground voltage. Over a second range of the pre-regulated supply voltage, the floating ground voltage is controlled to satisfy a first ratio metric relationship dependent on the pre-regulated supply voltage and the reference ground voltage. In a seventh implementation form of the level shifter system, according to the second aspect as such or any preceding implementation form of the second aspect, over a first range of a pre-regulated supply voltage, the floating supply voltage tracks a reference ground voltage. Over a second range of the pre-regulated supply voltage, the floating supply voltage is controlled to satisfy a second ratio metric relationship dependent on the pre-regulated supply voltage and the reference ground voltage.

A third aspect relates to a level shifter circuit comprising a first input stage configured to receive a first input signal; a second input stage configured to receive a second input signal complementary to the first input signal; a latch stage coupled to the first input stage and the second input stage, the latch stage including cross-coupled transistors configured to translate the first input signal and the second input signal to a first output signal and a second output signal; a first output stage coupled to the latch stage and configured to provide the first output signal; a second output stage coupled to the latch stage and configured to provide the second output signal; a floating voltage input stage configured to receive a floating ground voltage and a floating supply voltage; and a control stage configured to receive control signals and ensure the level shifter circuit operates within a predetermined voltage range.

In a first implementation form of the level shifter circuit, according to the third aspect as such, the first input stage includes a first n-channel metal-oxide-semiconductor (NMOS) transistor having a gate terminal coupled to receive the first input signal, the second input stage includes a second NMOS transistor having a gate terminal coupled to receive the second input signal, the first input stage further includes a third NMOS transistor coupled between the first NMOS transistor and the latch stage, and the second input stage further includes a fourth NMOS transistor coupled between the second NMOS transistor and the latch stage. In a second implementation form of the level shifter circuit, according to the third aspect as such or any preceding implementation form of the third aspect, a gate terminal of the third NMOS transistor and a gate terminal of the fourth NMOS transistor are coupled to receive a gated floating supply voltage derived from the floating supply voltage.

In a third implementation form of the level shifter circuit, according to the third aspect as such or any preceding implementation form of the third aspect, the latch stage includes a first pair of cross-coupled p-channel metal-oxide-semiconductor (PMOS) transistors and a second pair of cross-coupled NMOS transistors.

In a fourth implementation form of the level shifter circuit, according to the third aspect as such or any preceding implementation form of the third aspect, the control stage is configured to receive the control signals from a monitoring circuit that generates the control signals based on a pre-regulated supply voltage.

Although the description has been described in detail, it should be understood that various changes, substitutions, and alterations may be made without departing from the spirit and scope of this disclosure as defined by the appended claims. The same elements are designated with the same reference numbers in the various figures. Moreover, the scope of the disclosure is not intended to be limited to the particular embodiments described herein, as one of ordinary skill in the art will readily appreciate from this disclosure that processes, machines, manufacture, compositions of matter, means, methods, or steps, presently existing or later to be developed, may perform substantially the same function or achieve substantially the same result as the corresponding embodiments described herein. Accordingly, the appended claims are intended to include within their scope such processes, machines, manufacture, compositions of matter, means, methods, or steps.

The specification and drawings are, accordingly, to be regarded simply as an illustration of the disclosure as defined by the appended claims, and are contemplated to cover any and all modifications, variations, combinations, or equivalents that fall within the scope of the present disclosure.

**Claims**

1. A high-voltage tolerant level shifter circuit (400, 500), comprising:

    a first input terminal configured to receive a first pulse-width modulation, PWM, input signal ($CMD_P$);
    a second input terminal configured to receive a second PWM input signal ($CMD_N$) complementary to the first PWM input signal ($CMD_P$);
    a first output terminal configured to provide a first output signal ($OUT_P$);
    a second output terminal configured to provide a second output signal ($OUT_N$) complementary to the first output signal ($OUT_P$);
    a latch circuit coupled between the first input terminal and the first output terminal and between the second input terminal and the second output terminal, the latch circuit configured to translate the first PWM input signal ($CMD_P$) and the second PWM input signal ($CMD_N$) to the first output signal ($OUT_P$) and the second output signal ($OUT_N$);
    a floating ground voltage input terminal configured to receive a floating ground voltage ($Y_{FG}$);
    a floating supply voltage input terminal configured to receive a floating supply voltage ($V_{FS}$); and
    a control circuit (802) coupled to the latch circuit, the control circuit (802) configured to receive control signals ($OK_{IN}$) to ensure the high-voltage tolerant level shifter circuit (400, 500) operates within a known state.

2. The high-voltage tolerant level shifter circuit (400, 500) of claim 1, wherein the latch circuit includes:

    a first pair of cross-coupled p-channel metal-oxide-semiconductor, PMOS, transistors; and
    a second pair of cross-coupled n-channel metal-oxide-semiconductor, NMOS, transistors.

3. The high-voltage tolerant level shifter circuit (400, 500) of claim 1 or claim 2, further comprising:

    a first n-channel metal-oxide-semiconductor, NMOS, transistor (402) having a gate terminal coupled to the first input terminal;
    a second NMOS transistor (404) having a gate terminal coupled to the second input terminal;
    a third NMOS transistor (406) coupled between the first NMOS transistor and the latch circuit; and
    a fourth NMOS transistor (408) coupled between the second NMOS transistor and the latch circuit.

4. The high-voltage tolerant level shifter circuit (400, 500) of claim 3, wherein a gate terminal of the third NMOS transistor (406) and a gate terminal of the fourth NMOS transistor (408) are coupled to receive a gated floating supply voltage ($FS_{GATED}$).

5. The high-voltage tolerant level shifter circuit (400, 500) of any of the previous claims, wherein the floating ground voltage ($V_{FG}$) and the floating supply voltage ($V_{FS}$) are generated based on a pre-regulated supply voltage (103).

6. The high-voltage tolerant level shifter circuit (400, 500) of claim 5, wherein over a first range of the pre-regulated supply voltage (103), the floating ground voltage ($V_{FG}$) tracks a reference ground voltage (GND), and wherein over a second range of the pre-regulated supply voltage (103), the floating ground voltage ($V_{FG}$) is controlled to satisfy a first ratio metric relationship dependent on the pre-regulated supply voltage (103) and the reference ground voltage (GND).

7. The high-voltage tolerant level shifter circuit (400, 500) of claim 5 or claim 6, wherein over a first range of the pre-regulated supply voltage (103), the floating supply voltage ($V_{FS}$) tracks a reference ground voltage (GND), and wherein over a second range of the pre-regulated supply voltage (103), the floating supply voltage ($V_{FS}$) is controlled to satisfy a second ratio metric relationship dependent on the pre-regulated supply voltage (103) and the reference ground voltage (GND).

8. A level shifter system (800) comprising:

    a high-voltage tolerant level shifter circuit (400, 500) according to any of the previous claims;
    a floating ground voltage generator circuit (310) coupled to the floating ground voltage input terminal of the high-voltage tolerant level shifter circuit (400, 500) and configured to generate said floating ground voltage ($V_{FG}$); and

a floating supply voltage generator circuit (312) coupled to the floating supply voltage input terminal of the high-voltage tolerant level shifter circuit (400, 500) and configured to generate said floating supply voltage ($V_{FS}$).

9. The level shifter system (800) of claim 8, further comprising a monitoring circuit (600) configured to generate the control signals ($OK_{IN}$) based on a pre-regulated supply voltage (103).

10. The level shifter system (800) of claim 9, wherein the monitoring circuit (600) includes:

a voltage sensor (602) configured to measure the pre-regulated supply voltage (103);
a comparator (604) coupled to the voltage sensor (602) and configured to compare an output of the voltage sensor (602) with a reference voltage ($V_{REF}$); and
a control logic circuit (606) coupled to the comparator (604) and configured to generate the control signals ($OK_{IN}$) based on an output of the comparator (604).

11. The level shifter system (800) of any of claims 8 to 10, wherein the high-voltage tolerant level shifter circuit (400, 500) is according to claim 4, wherein said gated floating supply voltage ($FS_{GATED}$) is derived from the floating supply voltage ($V_{FS}$).

12. A level shifter circuit (400, 500) comprising:

a first input stage configured to receive a first input signal ($CMD_P$);
a second input stage configured to receive a second input signal ($CMD_N$) complementary to the first input signal ($CMD_P$);
a latch stage coupled to the first input stage and the second input stage, the latch stage including cross-coupled transistors configured to translate the first input signal and the second input signal to a first output signal ($OUT_P$) and a second output signal ($OUT_N$);
a first output stage coupled to the latch stage and configured to provide the first output signal ($OUT_P$);
a second output stage coupled to the latch stage and configured to provide the second output signal ($OUT_N$);
a floating voltage input stage configured to receive a floating ground voltage ($V_{FG}$) and a floating supply voltage ($V_{FS}$); and
a control stage configured to receive control signals ($OK_{IN}$) and ensure the level shifter circuit (400, 500) operates within a predetermined voltage range.

13. The level shifter circuit (400, 500) of claim 12, wherein the first input stage includes a first n-channel metal-oxide-semiconductor, NMOS, transistor (402) having a gate terminal coupled to receive the first input signal ($CMD_P$), wherein the second input stage includes a second NMOS transistor (404) having a gate terminal coupled to receive the second input signal ($CMD_N$), wherein the first input stage further includes a third NMOS transistor (406) coupled between the first NMOS transistor (402) and the latch stage, and wherein the second input stage further includes a fourth NMOS transistor (408) coupled between the second NMOS transistor (404) and the latch stage,
and wherein preferably a gate terminal of the third NMOS transistor (406) and a gate terminal of the fourth NMOS transistor (408) are coupled to receive a gated floating supply voltage ($FS_{GATED}$) derived from the floating supply voltage ($V_{FS}$).

14. The level shifter circuit (400, 500) of any of claims 12 to 13, wherein the latch stage includes:

a first pair of cross-coupled p-channel metal-oxide-semiconductor, PMOS, transistors; and
a second pair of cross-coupled NMOS transistors.

15. The level shifter circuit (400, 500) of any of claims 12 to 14, wherein the control stage is configured to receive the control signals ($OK_{IN}$) from a monitoring circuit (600) that generates the control signals based on a pre-regulated supply voltage (103).

FIG. 1

FIG. 2

FIG. 3

FIG. 4

FIG. 5

EP 4 727 013 A1

600

VOLTAGE SENSOR
602

$V_{IN}$

604

$V_{REF}$

LOGIC
CONTROLLER
CIRCUIT
606

OK$_{IN\_FS}$
OK$_{IN\_FG}$
OK$_{IN\_FG\_B}$
OK$_{IN\_FS\_B}$

FIG. 6

700

702

$V_{FB}$
$V_{REF}$

702

OSCILLATOR
706

PWM
GENERATOR
CIRCUIT
708

CMD$_P$

CMD$_N$

FIG. 7

800

PROCESSOR
802

MEMORY
804

SMPS SYSTEM
100

POWER SUPPLY
806

INTERFACE
808

FIG. 8

Europäisches
Patentamt

European
Patent Office

Office européen
des brevets

## EUROPEAN SEARCH REPORT

**Application Number**

EP 25 20 2098

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/207026 A1 (ASSAAD RIDA SHAWKY [US] ET AL) 4 July 2019 (2019-07-04) | 1-3,5-15 | INV.<br>H03K3/356 |
| A | * paragraph [0005] *<br>* paragraphs [0034], [0035], [0036]; figure 4 *<br>* paragraphs [0048] - [0050]; figure 6 *<br>* paragraph [0052]; figure 7 *<br>* paragraphs [0057], [0058], [0063]; figure 8 * | 4 | |
| X | EP 3 996 278 A1 (NXP BV [NL]) 11 May 2022 (2022-05-11) | 1,3-13, 15 | |
| A | * paragraphs [0010], [0012]; figure 2 *<br>* paragraphs [0018] - [0025]; figure 3 * | 2,14 | |
| A | US 2023/299762 A1 (SHAIK HUSSAINVALI [TW] ET AL) 21 September 2023 (2023-09-21)<br>* paragraphs [0085] - [0087]; figure 10 * | 1-15 | |

**TECHNICAL FIELDS SEARCHED (IPC)**

H03K

The present search report has been drawn up for all claims

| Place of search | Date of completion of the search | Examiner |
|---|---|---|
| Munich | 24 February 2026 | Martínez Martínez, J |

## ANNEX TO THE EUROPEAN SEARCH REPORT
## ON EUROPEAN PATENT APPLICATION NO.

EP 25 20 2098

This annex lists the patent family members relating to the patent documents cited in the above-mentioned European search report.
The members are as contained in the European Patent Office EDP file on
The European Patent Office is in no way liable for these particulars which are merely given for the purpose of information.

24-02-2026

| Patent document cited in search report | | Publication date | Patent family member(s) | | Publication date |
|---|---|---|---|---|---|
| US 2019207026 | A1 | 04-07-2019 | CN | 111357202 A | 30-06-2020 |
| | | | EP | 3732789 A1 | 04-11-2020 |
| | | | JP | 7429089 B2 | 07-02-2024 |
| | | | JP | 2021509558 A | 25-03-2021 |
| | | | US | 10103261 B1 | 16-10-2018 |
| | | | US | 2019207026 A1 | 04-07-2019 |
| | | | WO | 2019133257 A1 | 04-07-2019 |
| EP 3996278 | A1 | 11-05-2022 | CN | 114465616 A | 10-05-2022 |
| | | | EP | 3996278 A1 | 11-05-2022 |
| | | | US | 11251782 B1 | 15-02-2022 |
| US 2023299762 | A1 | 21-09-2023 | CN | 116800245 A | 22-09-2023 |
| | | | US | 2023299762 A1 | 21-09-2023 |

EPO FORM P0459

For more details about this annex : see Official Journal of the European Patent Office, No. 12/82